# EUROPÄISCHE PATENTSCHRIFT

(11) **EP 1 217 736 B1**
(45) Veröffentlichungstag und Bekanntmachung des Hinweises auf die Patenterteilung: **19.08.2009**
(21) Anmeldenummer: 01128952.7
(22) Anmeldetag: 06.12.2001
(51) Int. Cl.: H03H 11/48, H04R 3/02, H04R 3/04

(54) **Lautsprecher-Schaltung**
Loudspeaker circuit
Circuit de haut-parleur

(30) Priorität: 20.12.2000 DE 10063917
(43) Veröffentlichungstag der Anmeldung: 26.06.2002
(73) Patentinhaber: ELAC Electroacustic GmbH, 24113 Kiel (DE)
(72) Erfinder: Janke, Rolf, 24159 Kiel (DE); Sommerfeldt, Bjarne, 24214 Gettorf (DE)
(74) Vertreter: Tönnies, Jan G.

(56) Entgegenhaltungen:
- US-A- 4 051 385
- US-A- 4 306 256
- US-A- 4 944 015

## Beschreibung

Die Erfindung betrifft eine Lautsprecher-Schaltung, mit der Störgeräusche vermieden werden sollen, die immer dann auftreten, wenn die Elektronik und/oder die Lautsprecher-Chassis in ihrem Grenzarbeitsbereich betrieben werden.

Die US 4,051,385 gibt zwar einen Hinweis, wie ein aktives Netzwerk mit einem Gyrator Störgeräusche vermeidet, wenn in einem Receiver für Tonsignale das Tonsignal für Schaltzwecke verwendet wird.

Bisher wird dieses Problem in Kauf genommen oder - bei Aktiv-Subwoofern - mit eine Dioden-Clipper-Schalter eingesetzt, die die an die Lautsprecher-Chassis abgegebene Signalspannung abschwächt.

Eine Dioden-Clipper-Schaltung, die aus wenigstens zwei gegenläufig geschalteten Dioden zu Erde besteht, bewirkt, daß immer dann, wenn die Sinuswelle eine bestimmte Spannung überschreitet, die Dioden Strom durchlassen und damit die Spannungsspitzen abgeschwächt werden. Die Kennlinie der Dioden bestimmt dabei die Abschwächungscharakteristik.

Insgesamt wird bewirkt, daß das Signal ab einer gewissen Aussteuerung sanft verrundet wird. Nachteil dieser Dioden-Clipper-Schaltung ist dabei aber eine Dynamik-Kompression über den gesamten Frequenzbereich hindurch und zudem eine merkliche Klangverzerrung bereits bei niedrigen Pegeln.

Die Erfindung stellt sich die nun zur Aufgabe, eine Schaltung zu entwickeln, bei der mit geringem Bauteile-Aufwand die Störgeräusche vermieden werden können.

Erfindungsgemäß wird dies durch eine Schaltung mit den Merkmalen des Hauptanspruches gelöst. Die Unteransprüche geben vorteilhafte Ausführungsformen der Erfindung wieder.

Insbesondere ist vorteilhaft, daß durch die Dioden-Clipper-Schaltung, die das Signal bei kleinen Pegeln nahezu unbeeinflußt läßt, da mehrere Dioden in Reihe geschaltet sind, für niedrige Frequenzen durch die Induktivität eine frequenzabhängige Überbrückung geschaffen wird, so daß die Kompression mit fallender Frequenz zunimmt. Dieses sonst nur durch aufwendige Schaltungen und Software erreichbare Verhalten wird durch die erfindungsgemäße Schaltung mit einem vorteilhaften Phasen- und Einschwingverhalten erreicht, wobei für gegebene Verstärker-Chassis-Konfigurationen Grenzfrequenz und Stärke der Kompression auf die Mechanik des Chassis und die maximale Leistung des Verstärkers durch einfache Dimensionierung billiger Bauteile abgeglichen werden können.

Im Gegensatz zu herkömmlichen aktiven Systemen, bei denen ein Pumpen auftritt, ist durch die Kennlinie der Dioden das Einschwingverhalten exakt bestimmbar.

Da bei derartigen Filterschaltungen bei akzeptabler Anschlußimpedanz Induktivitäten im Mehrere-Henry-Bereich auftreten, wird vorgeschlagen, die erforderliche Induktivität durch eine aktive Nachbildung mit Hilfe eines Gyrators zu erreichen. Je nach gewünschter Kompression läßt sich die Schaltung in verschiedenen Filter-Ordnungen aufbauen. Ebenso kann der Einsatzpunkt der Kompression durch die Anzahl der Dioden und den Abgriff für die Induktivität im Dioden-Clipper-Kreis, an dem sich für diesen Zweck die beiden Wege des Kreises verbinden, leicht variieren.

Weitere Merkmale und Vorteile der Erfindung ergeben sich aus nachfolgender Beschreibung eines bevorzugten Ausführungsbeispiels anhand der beigefügten Zeichnung. Dabei zeigt:

Die einzige Figur
eine Schaltung, in der zwischen zwei Operationsverstärkern eine Kapazität, ein Dioden-Clipper-Kreis, sowie an diesem eine Induktivität dargestellt sind.

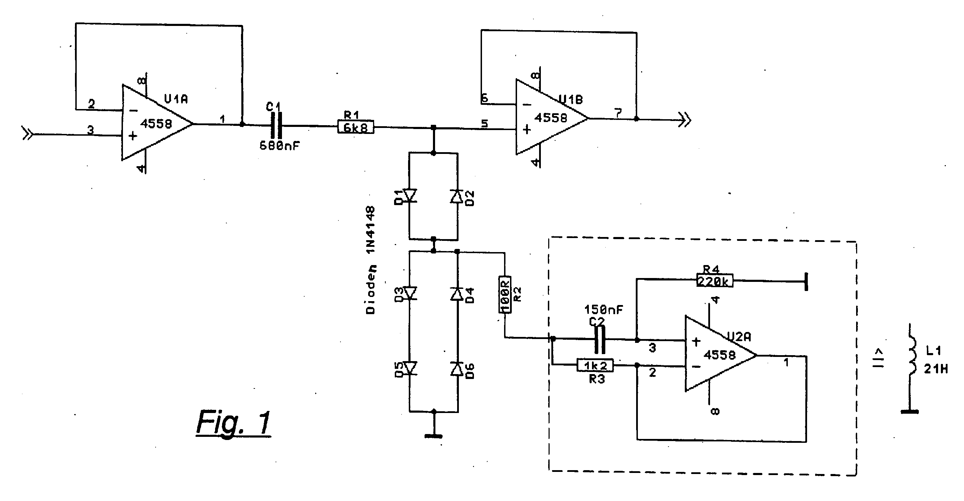

In der Fig. 1 sind zwei Operationsverstärker 10 und 20 nur dafür stellvertretend aufgeführt, daß ein niederohmiger Ausgangswiderstand bzw. ein hochohmiger Abgriff an der in der Mitte befindlichen Schaltung erfolgt. Der Kondensator C1 ist dabei im Beispiel mit 680 mF ausgelegt, während die Induktivität L1, die sich in dem durch die durchbrochene Linie hervorgehobenen Kästchen befindet, ungefähr eine Größe von 21 Henry besitzt. Daß es sich um eine Induktivität handelt, ist durch das Äquivalenzsymbol und die rechts daneben befindliche Symboldarstellung verdeutlicht.

Diese Induktivität ist nun über einen Widerstand R2 von beispielsweise 100 Ohm mit dem Verbindungspunkt Y innerhalb des Dioden-Clipper-Kreises verbunden, der den Dioden-Clipper-Kreis in einen ersten Teil-Kreis und einen zweiten Teil-Kreis unterteilt.

In der Darstellung ist der zweite Teilkreis mit insgesamt vier Dioden in zwei Wegen, die jeweils in Serie geschaltet sind, wobei die beiden Wege an die parallel zueinander verlaufen aufgeteilt. Bei einem beispielhaften Durchlaßgrenzwert von 0,6 V ergibt sich so für die gesamte Dioden-Clipper-Schaltung ungefähr bei 1,8 Volt der Effekt, daß die Dioden (im Moment unbeachtlich der Induktivität L1) bei Überschreiten von 1,8 Volt eine Verrundung der angelegten Spannung (links in der Zeichnung als "Input" verdeutlicht) bewirken, so daß diese Verrundung an der rechten Seite ("Output", die den Ausgang der Schaltung verdeutlicht) bewirkt wird.

Dadurch, daß nun jedoch eine Induktivität parallel zu dem zweiten Teilkreis geschaltet ist, wird sich bei geringen Frequenzen, beispielsweise 25 Hz, ein Hochpaß zweiter Ordnung bilden, der bewirkt, daß lediglich der erste Dioden-Clipper-Teilkreis wirksam ist, also schon bei 0,6 V Sinusüberschreitung die Dioden immer mehr leiten.

Entsprechend werden die Lautsprecher-Chassis bei geringen Frequenzen mit weniger Spannung versorgt, so daß sie nicht mehr die Störgeräusche produzieren, die gerade bei niedrigen Frequenzen auftreten, da gerade in diesem Fall das Problem auftritt, daß die Lautsprecher-Chassis mit viel Hub ohne großen Widerstand arbeiten, weil das Luftvolumen an den Lautsprechern erst bei höheren Frequenzen als Widerstand wirkt.

Ein Widerstand R2 (z.B. 100 Ohm), der zwischen Dioden-Clipper-Schaltkreis und Induktivität L1 geschaltet ist, begrenzt die Dämpfung auf einen endlichen Wert, da es sonst Schwankungen im Einschwingverhalten geben würde.

Innerhalb des gestrichelten Kästchens befindet sich eine Gyrator-Schaltung, mit der eine Mehrere-Henry-Spule aktiv nachgebildet werden kann. Sie besteht aus eine Operationsverstärker 4558, Bezugszeichen 30, der an seinem positiven Eingang an einen Kondensator C2 mit 150 mF gekoppelt ist und an dessen positiven Eingang weiter über einen Widerstand R3 mit 220 kOHM eine Verbindung zum Erdniveau erreicht ist. Am Rückkopplungsanschluß des Operationsverstärkers befindet sich noch ein Widerstand R3, der vor dem Kondensator nach dem Widerstand R2 angeschlossen ist und beispielsweise 1 kOhm dimensioniert ist.

## Patentansprüche

1. Lautsprecher-Schaltung, **gekennzeichnet durch** einen Hochpass aus einer Kapazität (C1) und einer Induktivität (L1) und einem Dioden-Clipper-Kreis, wobei die Induktivität (L1) an einem Verbindungspunkt innerhalb des Dioden-Clipper-Kreises angekoppelt ist, der den Dioden-Clipper-Kreis in einen ersten Teil-Kreis und einen zweiten Teilkreis unterteilt.

2. Lautsprecher-Schaltung nach Anspruch 1, **dadurch gekennzeichnet, dass** die Induktivität (L1) durch eine Gyrator-Schaltung nachgebildet ist.

3. Lautsprecher-Schaltung nach einem der vorangehenden Ansprüche, **dadurch gekennzeichnet, dass** der Verbindungspunkt innerhalb des Dioden-Clipper-Kreises einen ersten Teilkreis abtrennt, der dem Kondensator (C1) und einem nachfolgenden Widerstand (R1) angeschlossen ist, während der zweite Teilkreis durch die Induktivität (L1) zu Erde frequenzabhängig überbrückt wird.

4. Lautsprecher-Schaltung nach Anspruch 3, **dadurch gekennzeichnet, dass** der erste Teilkreis zwei entgegengerichtete Dioden umfasst und der zweite Teilkreis insgesamt vier Dioden in zwei Wegen umfasst, wobei in jedem Weg zwei Dioden in gleicher Richtung in Serie geschaltet sind, während in dem anderen Weg die Richtung umgekehrt ist.

## Claims

1. Speaker circuit, **characterized by** a high pass from a capacity (C1) and an inductance (L1) and a diode clipper circuit, the inductance (L1) being connected at a connection point within the diode clipper circuit which divides the diode Clipper-circuit in a first sub-circuit and a second sub-circuit.

2. Speaker circuit according to claim 1, **characterized in that** the inductance (L1) is made up by a Gyrator circuit.

3. Speaker circuit according to one of the preceding claims, **characterized in that** the connection point within the diode clipper separates a first sub-circuit, which is connected to the capacitor (C1) and a subsequent resistance (R1), while the second sub-circuit is bridged by the inductance (L1) frequency-dependent to ground.

4. Speaker circuit according to claim 3, **characterized in that** the first sub-circuit comprises two diodes reversed to each other and the second sub-circuit a total of four diodes in two ways, in each way two diodes coupled in series in the same direction, while in the other way the direction is reversed.

## Revendications

1. Circuit de haut-parleur, **caractérisé par** un passe-haut constitué par une capacité (C1) et une inductance (L1) et un circuit écrêteur à diodes, ladite inductance (L1) étant couplée sur un point de connexion à l'intérieur du circuit écrêteur à diodes, qui divise le circuit écrêteur à diodes en un premier sous-circuit et en un deuxième sous-circuit.

2. Circuit de haut-parleur selon la revendication 1, **caractérisé par le fait que** ladite inductance (L1) est constituée par un circuit gyrateur.

3. Circuit de haut-parleur selon l'une quelconque des revendications précédentes, **caractérisé par le fait que** le point de connexion à l'intérieur du circuit écrêteur à diodes sépare un premier sous-circuit qui est connecté au condensateur (C1) et à une résistance (R1) suivante, tandis que le deuxième sous-circuit est ponté par l'inductance (L1), en fonction de la fréquence, à la terre.

4. Circuit de haut-parleur selon la revendication 3, **caractérisé par le fait que** ledit premier sous-circuit comprend deux diodes opposées et le deuxième sous-circuit comprend, dans l'ensemble, quatre diodes sur deux voies, sur chacune des voies deux diodes étant montées en série dans la même direction, tandis que, sur l'autre voie, la direction est inversée.
